# EUROPÄISCHE PATENTSCHRIFT

(11) **EP 0 650 259 B1**
(45) Veröffentlichungstag und Bekanntmachung des Hinweises auf die Patenterteilung: **25.11.1998**
(21) Anmeldenummer: 94116296.8
(22) Anmeldetag: 15.10.1994
(51) Int. Cl.: H03L 7/14, H03L 7/07

(54) **Schaltungsanordnung für einen Taktgenerator**
Clock signal generator circuit
Circuit générateur de signaux d'horloge

(30) Priorität: 23.10.1993 DE 4336239
(43) Veröffentlichungstag der Anmeldung: 26.04.1995
(73) Patentinhaber: ALCATEL ALSTHOM COMPAGNIE GENERALE D'ELECTRICITE, 75008 Paris (FR)
(72) Erfinder: Rieder, Klaus-Hartwig, D-70195 Stuttgart (DE)
(74) Vertreter: Müller, Joachim, Dipl.-Ing.

(56) Entgegenhaltungen:
- EP-A- 0 224 884
- EP-A- 0 347 737
- EP-A- 0 509 706

## Beschreibung

Die Erfindung betrifft eine Schaltungsanordnung für einen Taktgenerator, die in digitalen Nachrichtennetzen eingesetzt wird. Um eine störungsfreie Datenübertragung zu gewährleisten, werden an diese Taktgeneratoren sehr hohe Anforderungen an die Genauigkeit und Stabilität gestellt. So ist es bekannt, für diese Zwecke mikroprozessorgesteuerte digitale Phasenregelkreise einzusetzen, vgl. Ernst, W., Hartmann, H.L.: Neue Taktgeneratoren für EWSD. telcom report 9 (1986) Heft 4, S. 263-269. Bei derartigen Taktgeneratoren tritt das Problem auf, daß an den Phasenregelkreis sich widersprechende Forderungen gestellt werden. So soll einerseits die Bandbreite des Phasenregelkreises möglichst groß sein, um die Forderungen für den Phasenzeitfehler, engl. Time Interval Error, zu erfüllen, andererseits soll die Bandbreite möglichst klein sein, damit der Einfluß von Jitter und Wander auf die Taktgenauigkeit bei Ausfall des externen Referenztaktes gering ist. Um diese gegensätzlichen Forderungen erfüllen zu können, werden bei bekannten Taktgeneratoren sehr teure hochstabile Quarzoszillatoren eingesetzt, allerdings mit dem physikalisch bedingten Kompromiß, daß insbesondere bei Ausfall des Referenztaktes die durch die Eigenschaften des Quarzoszillators, wie zum Beispiel Eigenstabilität, bedingten Abweichungen der Taktfrequenz wirksam werden.

Aufgabe der Erfindung ist es nun, eine Schaltungsanordnung für einen kostengünstigen Taktgenerator anzugeben, der einen von einem Referenztakt abgeleiteten und mit diesem synchronen Takt hoher Frequenzstabilität liefert und der bei Ausfall des Referenztaktes seine Frequenz mit hoher Genauigkeit beibehalten soll.

Diese Aufgabe wird durch die im Hauptanspruch angegebenen Merkmale erfüllt. In den Unteransprüchen sind detaillierte Realisierungsmöglichkeiten für eine Schaltungsanordnung angegeben.

Das Wesen der Erfindung besteht darin, daß die sich widersprechenden Forderungen an einen Phasenregelkreis nicht von einem Phasenregelkreis erfüllt werden, sondern daß der Taktgenerator zwei Phasenregelkreise enthält von denen jeweils einer für bestimmte Eigenschaften optimiert wird. Obwohl zwei digitale Phasenregelkreise vorhanden sind, wird vorteilhafterweise dennoch nur ein hochstabiler Quarzoszillator und nur ein Mikroprozessor eingesetzt. An den in der erfindungsgemäßen Schaltungsanordnung eingesetzten Quarzoszillator werden im Vergleich zu dem in den bisher bekannten Taktgeneratoren angewendeten Quarzoszillatoren geringere Anforderungen gestellt, so daß damit die Schaltungsanordnung kostengünstiger wird. Der erste Phasenregelkreis hat die Aufgabe, einen hochgenauen Takt bereitzustellen, falls der externe Takt ausfallen sollte. Er hat daher eine geringe Bandbreite, beispielsweise 0,001 Hz, und bedingt dadurch einen jedoch in dieser Schaltungsanordnung nicht störenden großen Phasenzeitfehler. Der zweite Phasenregelkreis hat die Aufgabe, den zu verteilenden Systemtakt zu erzeugen. Dieser Phasenregelkreis hat eine relativ große Bandbreite, beispielsweise 0,1 Hz, und daher einen geringen Phasenzeitfehler.

Somit wird eine Schaltungsanordnung für einen Taktgenerator angegeben, mit der bei Einsatz eines im Vergleich zu bekannten Lösungen weniger stabilen und damit kostengünstigeren Quarzoszillators ein Taktgenerator hoher Güte und Zuverlässigkeit auch bei Ausfall des Referenztaktes realisiert wird.

Die Erfindung wird nachstehend an einem Ausführungsbeispiel erläutert. In der dazugehörigen Zeichnung zeigen
- Fig. 1: ein Blockschaltbild der erfindungsgemäßen Schaltungsanordnung und
- Fig. 2: ein Schaltbild der erfindungsgemäßen Schaltungsanordnung.

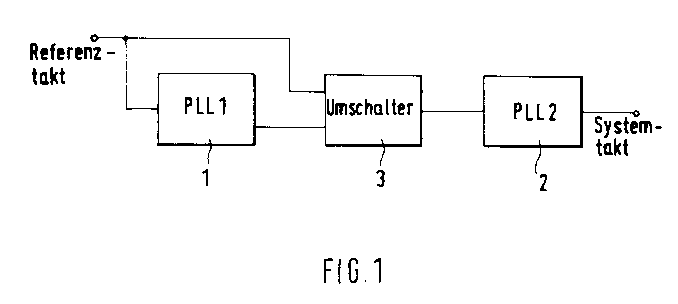

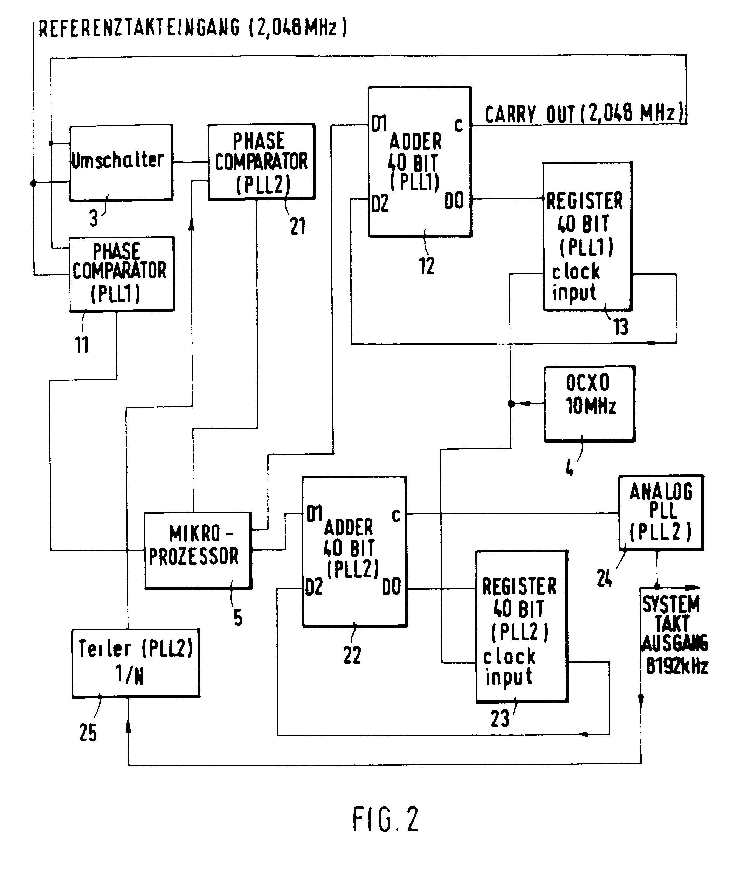

Gemäß Fig. 1 besteht die Schaltungsanordnung für einen Taktgenerator aus einem ersten Phasenregelkreis 1, einem zweiten Phasenregelkreis 2 und einem Umschalter 3. Im Normalbetrieb wird der Oszillator des ersten und zweiten Phasenregelkreises 1, 2 mit dem jeweils am Eingang liegenden Referenztakt synchronisiert. Das Vorhandensein des Referenztaktes wird durch einen in der Fig. 1 nicht dargestellten Impulsausfalldetektor überwacht. Sollte der externe Referenztakt ausfallen, so bewirkt der Impulsausfalldetektor, daß der Umschalter 3 von dem externen Referenztakt auf einen internen, nunmehr von dem ersten Phasenregelkreis 1 gelieferten Takt umschaltet, der dann Referenztakt für den zweiten Phasenregelkreis 2 wird. So kann vorteilhafterweise der erste Phasenregelkreis 1 bezüglich der Frequenzgenauigkeit seiner Ausgangsfrequenz optimiert werden, um bei Ausfall des externen Referenztaktes für den zweiten Phasenregelkreis 2 einen hochgenauen internen Referenztakt bereitstellen zu können. Jitter und Wander haben dabei einen sehr geringen Einfluß auf die Frequenzgenauigkeit. Der erste Phasenregelkreis 1 wird auch hinsichtlich der Frequenzüberwachung des externen Referenztaktes optimiert. Da der Phasenregelkreis eine sehr geringe Bandbreite hat, folgt er Frequenzänderungen des Referenztaktes nur sehr langsam. Frequenzänderungen des Referenztaktes können dadurch besser erkannt werden. Der zweite Phasenregelkreis hat eine relativ große Bandbreite und wird somit bezüglich eines geringen Phasenzeitfehlers optimiert. Außerdem ist er stark bedämpft, um die Jitterverstärkungsüberhöhung in vorgegebenen Grenzen zu halten. Fig. 2 zeigt Details der Schaltungsanordnung. Beiden Phasenregelkreisen gemeinsam ist ein thermostatstabilisierter Festfrequenzgenerator 4 und ein Mikroprozessor 5. Der erste Phasenregelkreis besteht darüber hinaus aus einem Phasenkomparator 11, einem Addierer 12 und einem Register 13. Der zweite Phasenregelkreis enthält vergleichbare Baugruppen, nämlich Phasenkomparator 21, Addierer 22 und Register 23 und zusätzlich einen analogen Phasenregelkreis 24 einfacher Bauart mit einem vergleichsweise billigen spannungsgesteuerten Quarzoszillator. Diesem analogen Phasenregelkreis 24 ist ein Frequenzteiler 25 nachgeschaltet. Addierer 12, 22 und Register 13, 23 bilden einen variablen Frequenzteiler, der vom Mikroprozessor 5 in sehr kleinen Schritten eingestellt wird. Die Zusammenschaltung aus dem Mikroprozessor 5 mit dem jeweiligen Addierer 12, 22 und dem jeweiligen Register 13, 23 wirkt wie ein variabler Oszillator. Der Festfrequenzgenerator 4 taktet das jeweilige Register 13, 23, dessen Inhalt in dem jeweiligen Addierer 12, 22 zu einem von dem Mikroprozessor 5 gelieferten digitalen Stellwert addiert wird. Am Carry-Ausgang c des Addierers 12, 22 entsteht dann eine Impulsfolge, deren Frequenz durch den digitalen Stellwert des Mikroprozessors 5 in kleinen Schritten variiert werden kann. Da diese Impulsfolge jitterbehaftet ist, ist zur Filterung des Jitters im zweiten Phasenregelkreis ausgangsseitig der analoge Phasenregelkreis 24 vorgesehen, um einen jitterarmen Systemtakt zu liefern. Im vorliegenden Beispiel wird außerdem die erzeugte Frequenz f₁ = 2,048 MHz von dem analogen Phasenregelkreis 24 auf die im System benötigte Frequenz f₂ = 8,192 MHz umgesetzt. Der Frequenzteiler 25 teilt die Frequenz des Systemtaktes auf die Frequenz des Referenztaktes. Durch den Mikroprozessor 5 werden die oben beschriebenen charakteristischen Eigenschaften des ersten und zweiten Phasenregelkreises bewirkt.

In Fig. 1 und Fig. 2 ist die Überwachung des externen Referenztaktes nicht dargestellt. Sie erfolgt über einen Impulsausfalldetektor und/oder über den Phasenkomparator 11 des ersten Phasenregelkreises 1. Falls mehrere Eingänge überwacht werden müssen, wird jedem Eingang ein Phasenkomparator zugeordnet. Der Jitter des ersten Phasenregelkreises 1 stört bei der Frequenzüberwachung nicht, wenn Phasenkomparatoren verwendet werden, die einen Mittelwert der Phase über eine bestimmte Zeit, beispielsweise über 100 ms, bilden. Anstelle der in Fig. 2 dargestellten numerisch gesteuerten Oszillatoren können auch andere Ausführungen verwendet werden. Falls eine Einrichtung in einem digitalen Nachrichtennetz längere Zeit ohne externen Referenztakt betrieben werden soll, ist es aus Zuverlässigkeitsgründen zweckmäßig, mehr als zwei Quarzoszillatoren, die in einem gedoppelten Taktsystem vorhanden sind, im System einzusetzen. Dann kann bei Frequenzabweichungen durch Mehrheitsentscheidung der abweichende Oszillator gefunden werden. In diesem Fall können der erste und der zweite Phasenregelkreis mit getrennten thermostatstabilisierten Quarzoszillatoren betrieben werden.

## Patentansprüche

1. Schaltungsanordnung für einen Taktgenerator in digitalen Nachrichtennetzen, dessen Ausgangstakt bezüglich Frequenz und Phasenlage mit der Frequenz und Phasenlage eines Referenztaktes verglichen wird, **dadurch gekennzeichnet,** daß ein erster Phasenregelkreis (1) über einen Umschalter (3) mit einem zweiten Phasenregelkreis (2) verbunden ist und daß im Normalbetrieb ein Referenztakt direkt dem ersten Phasenregelkreis (1) und über den Umschalter (3) dem zweiten Phasenregelkreis (2) zugeführt wird und daß bei Ausfall des Referenztaktes über den Umschalter (3) bewirkt wird, daß der Ausgangstakt des ersten Phasenregelkreises (1) anstelle des Referenztaktes dem zweiten Phasenregelkreis (2) zugeführt wird, an dessen Ausgang der Systemtakt bereitgestellt wird.

2. Schaltungsanordnung für einen Taktgenerator nach Anspruch 1, dadurch gekennzeichnet, daß der erste Phasenregelkreis (1) und der zweite Phasenregelkreis (2) jeweils einen Phasenkomparator (11, 21) und jeweils einen in Abhängigkeit vom jeweiligen Ausgangssignal der Phasenkomparatoren (11, 21) mikroprozessorgesteuerten variablen Oszillator enthalten, der aus einem zu beiden Phasenregelkreisen zugeordneten Festfrequenzgenerator (4) mit jeweils nachgeschaltetem Register (13, 23) und Addierer (12, 22) besteht, und daß der Ausgang des Phasenkomparators (11) des ersten Phasenregelkreises und der Ausgang des Phasenkomparators (21) des zweiten Phasenregelkreises mit einem Mikroprozessor (5) verbunden ist, der seinerseits jeweils mit dem Addierer (12, 22) im ersten und zweiten Phasenregelkreis verbunden ist.

3. Schaltungsanordnung für einen Taktgenerator nach Anspruch 2, dadurch gekennzeichnet, daß dem Addierer (22) des zweiten Phasenregelkreises ein analoger Phasenregelkreis (24) zwecks Filterung des Jitters nachgeschaltet ist.

## Claims

1. A circuit arrangement for a clock generator in digital communications networks which generates a clock signal that is compared in frequency and phase with a reference clock signal, **characterized in that** a first phase-locked loop (1) is connected via a switch (3) to a second phase-locked loop (2), that during normal operation, a reference clock signal is applied directly to the first phase-locked loop (1) and is applied to the second phase-locked loop (2) through the switch (3), and that in the event of a failure of the reference clock signal, the switch (3) is caused to apply, instead of the reference clock signal, the output of the first phase-locked loop (1) to the second phase-locked loop (2), which provides the system clock signal.

2. A circuit arrangement for a clock generator as claimed in claim 1, characterized in that the first and second phase-locked loops each comprise a phase detector (11, 21) and a variable-frequency oscillator which consists of a fixed-frequency generator (4) associated with both phase-locked loops and followed in each phase-locked loop by a register (13, 23) and an adder (12, 22), said variable-frequency oscillator being microprocessor-controlled according to the output signal from the respective phase detector (11, 21), and that the output of the phase detector (11) of the first phase-locked loop and the output of the phase comparator (21) of the second phase-locked loop are connected to a microprocessor (5) which, in turn, is connected to the adders (12, 22) in the first and second phase-locked loops.

3. A circuit arrangement for a clock generator as claimed in claim 2, characterized in that the adder (22) of the second phase-locked loop is followed by an analog phase-locked loop (24) for filtering jitter.

## Revendications

1. Circuit générateur de signaux d'horloge dans des réseaux de télécommunication numériques dont le signal d'horloge de sortie est comparé, du point de vue de la fréquence et de la position de phase, à la fréquence et à la position de phase d'un signal d'horloge de référence, caractérisé en ce qu'une première boucle d'asservissement de phase (1) est reliée à une seconde boucle d'asservissement de phase (2) par l'intermédiaire d'un commutateur (3), en ce que, durant le fonctionnement normal, un signal d'horloge de référence est amené directement à la première boucle d'asservissement de phase 1 (1) et à la seconde boucle d'asservissement de phase (2) par l'intermédiaire du commutateur (3) et en ce que, en cas de défaillance du signal d'horloge de référence, on fait en sorte, par l'intermédiaire du commutateur (3), d'amener, à la place du signal d'horloge de référence, le signal d'horloge de sortie de la première boucle d'asservissement de phase (1), à la seconde boucle d'asservissement de phase (2) à la sortie de laquelle le signal d'horloge du système est mis à disposition.

2. Circuit générateur de signaux d'horloge selon la revendication 1, caractérisé en ce que la première boucle d'asservissement de phase (1) et la seconde boucle d'asservissement de phase (2) comportent respectivement un comparateur de phase (11, 21) et respectivement un oscillateur qui est commandé par microprocesseur, varie en fonction du signal de sortie respectif des comparateurs de phase (11, 21) et qui se compose d'un générateur de fréquences fixes (4) affecté aux deux boucles d'asservissement de phase et comportant un enregistreur (13, 23) respectivement placé en aval ainsi qu'un additionneur (12, 22) et en ce que la sortie du comparateur de phase (11) de la première boucle d'asservissement de phase et la sortie du comparateur de phase (21) de la seconde boucle d'asservissement de phase sont reliées à un microprocesseur (5) qui à son tour, est relié respectivement à l'additionneur (12, 22) dans la première et la seconde boucle d'asservissement de phase.

3. Circuit générateur de signaux d'horloge selon la revendication 2, caractérisé en ce qu'une boucle d'asservissement de phase (24) analogique est placée après l'additionneur (22) de la seconde boucle d'asservissement de phase.
